# EUROPÄISCHE PATENTSCHRIFT

(11) **EP 0 683 516 B1**
(45) Veröffentlichungstag und Bekanntmachung des Hinweises auf die Patenterteilung: **11.01.2006**
(21) Anmeldenummer: 95106940.0
(22) Anmeldetag: 08.05.1995
(51) Int. Cl.: H01L 23/14, H05K 3/46

(54) **Mehrlagenleiterplatten und Multichipmodul-Substrate**
Multilayer circuit board and multichip module substrate
Circuit imprimé à multi-couches et substrat pour module à multi-puces

(30) Priorität: 20.05.1994 DE 4417775
(43) Veröffentlichungstag der Anmeldung: 22.11.1995
(73) Patentinhaber: Infineon Technologies AG, 81669 München (DE)
(72) Erfinder: Hammerschmidt, Albert, Dr., D-91056 Erlangen (DE); Birkle, Siegfried, Dr., D-91315 Höchstadt (DE)
(74) Vertreter: Müller - Hoffmann & Partner

(56) Entgegenhaltungen:
- EP-A- 0 381 109
- EP-A- 0 498 258
- US-A- 5 147 822
- FALBE, REGITZ: "Römpp Chemie Lexikon", 1990, GEORG THIEME VERLAG, STUTTGART, NEW YORK

## Beschreibung

Die Erfindung.betrifft Mehrlagenleiterplatten und Multichipmodul-Substrate mit wenigstens einem schichtförmigen Verbund aus hochtemperaturbeständigen Kunststoff und metallischen Leiterbahnen sowie ein Verfahren zu deren Herstellung.

Multichipmodule (MCM) sind Bauelemente, welche integrierte Schaltungen, wie Speicher- und Logikbausteine, untereinander und mit der Peripherie verbinden; die dabei resultierenden verkürzten Strompfade erlauben niedrigere Signallaufzeiten und eine höhere Taktfrequenz. Die Multichipmodule werden in Mehrlagentechnik hergestellt, wobei als Substratmaterial Keramik oder Silicium verwendet werden kann. Als Substrat können ferner auch Leiterplatten dienen, welche - ebenso wie Keramikmaterialien - einen Mehrschichtaufbau aufweisen können. Die eigentliche Mikroverdrahtung auf dem Substrat (bis zu 25 Leiterlagen und mehr) besteht aus Kupferleitungen, die voneinander durch ein organisches Dielektrikum, wie Polyimid, isoliert sind. Durchkontaktierungen von einer Kupfer-Leitbahnebene zur nächsten verbinden die einzelnen Kupferlagen elektrisch (siehe dazu: "IEEE Spectrum", Vol. 27 (1990), No. 3, Seiten 34 bis 36, 46 und 48; "The International Journal for Hybrid Microelectronics", Vol. 13 (1990), No. 4, Seiten 91 bis 99; "VDI Berichte", Nr. 933 (1991), Seiten 265 bis 283).

Organische Dielektrika erlauben - aufgrund der niedrigen Dielektrizitätskonstante - höhere Taktraten als keramische Isolationsschichten; höhere Taktraten sind künftig aber vermehrt erforderlich. Verwendet werden vor allem hochtemperaturstabile organische Polymere, wie Polyimide und Polybenzocyclobutene, da diese den elektrischen Anforderungen (niedrige Dielektrizitätskonstante, niedriger Verlustwinkel) und den thermischen Anforderungen (Stabilität bei Lötprozessen) weitgehend entsprechen.

Hochtemperaturbeständige organische Dielektrika, wie Polyimide, haben allerdings die Eigenschaft, aus der Umgebungsfeuchte etwa bis zu 4 Masse-% Wasser aufzunehmen (A. Hammerschmidt et al., 1st European Technical Symposium on Polyimides, 10. bis 11. Mai 1989, Montpellier, Frankreich). Dadurch werden aber die elektrischen Eigenschaften, vor allem die Dielektrizitätskonstante, negativ beeinflußt. Dies wiederum führt zu einer Beeinträchtigung des Schaltverhaltens (Taktfrequenz) des Gesamtbauteils. Ferner können durch die Feuchtigkeit Korrosionsvorgänge im Innern der Multichipmodule initiiert bzw. beschleunigt werden.

Derzeit werden auf Multichipmodule mit organischen Dielektrika keine Feuchtesperren aufgebracht. Durch Kapselung, Unterbringung in klimatisierten Bereichen und Schichtdicken bis zu 60 µm pro Lage ist nämlich eine Feuchtesperre nicht unbedingt notwendig. Bei neuen Aufbaukonzepten mit einer Schichtdicke des Dielektrikums von 15 bis 20 µm pro Lage sowie bei Low-cost-Anwendungen ist ein derartiger Schutz jedoch erforderlich.

Bei integrierten Schaltungen in Mehrlagenaufbau mit organischen Dielektrika (bis zu 3 Leitbahnebenen; Schichtdicke des Dielektrikums: 1 bis 2 µm) werden - zur Unterdrückung der bei Feuchtewechseln auftretenden dielektrischen Veränderungen - die planarisierenden Dielektrika mit einer als Feuchtesperre wirkenden Schicht aus Siliciumnitrid, sogenanntes Plasmanitrid, abgedeckt (siehe dazu: Fachtagung "Polymerwerkstoffe für die Elektronik", 14. - 16. Oktober 1987, Würzburg, Tagungsbericht (1987), Seiten 153 bis 165). Siliciumnitrid hat jedoch den Nachteil, sogar bei Schichtdicken unterhalb 0,25 µm spröde zu sein. Außerdem muß zur erforderlichen Strukturierung des Siliciumnitrids (zum Freilegen von Kontaktpads) ein anderer Ätzprozeß (Fluorätzung) angewendet werden als zur Strukturierung des darunter befindlichen organischen Dielektrikums, wie Polyimid (O₂/RIE oder Naßätzung).

Um die mit Siliciumnitrid verbundenen Nachteile zu vermeiden, ist es bereits bekannt, bei integrierten Schaltungen amorphen wasserstoffhaltigen Kohlenstoff als Coating zu verwenden (siehe dazu EP-OS 0 381 109). Von kompressivem Streß kann hierbei jedoch ein ungünstiger Einfluß ausgehen.

Aufgabe der Erfindung ist es, Kunststoffschichten umfassende Mehrlagenleiterplatten und Multichipmodul-Substrate der eingangs genannten Art derart auszugestalten, daß sie eine wirksame Feuchtesperre aufweisen.

Dies wird erfindungsgemäß dadurch erreicht, daß der Kunststoff mit einer dünnen Schicht aus amorphem wasserstoffhaltigem Kohlenstoff (a-C:H) mit einem Wasserpermeationskoeffizient < 1,1·10⁻¹³ m³/s versehen ist, und daß die a-C:H-Schicht bezüglich der Härte einen Gradient besitzt, wobei der an den Kunststoff angrenzende Bereich eine geringere Härte aufweist als der äußere Bereich.

Die Mehrlagenleiterplatten und Multichipmodul-Substrate nach der Erfindung weisen stoffschlüssige, pinhole-freie a-C:H-Schichten auf, die weitgehend wasserundurchlässig sind. Die a-C:H-Schichten zeichnen sich ferner durch eine gute Haftfestigkeit auf den hochtemperaturstabilen Polymeren aus und können spezifische Leitfähigkeiten bis zu 10¹⁸ Ω·cm sowie einen optischen Bandabstand zwischen 1 und 2,7 eV besitzen. Ein weiterer Vorteil der a-C:H-Schichten liegt in der Strukturierbarkeit. Im Gegensatz zu Siliciumnitrid läßt sich nämlich bei amorphem wasserstoffhaltigem Kohlenstoff derselbe Prozeß verwenden wie bei der Strukturierung des darunter befindlichen Dielektrikums (siliciumhaltiger Photolack - O₂/RIE).

Der ungünstige Einfluß von kompressivem Streß wird durch den Härtegradient der a-C:H-Schichten minimiert, wobei der an die Kunststoffschicht angrenzende Bereich der a-C:H-Schicht weicher ist als deren äußerer Bereich, d.h. eine geringere Härte aufweist. Hierbei wirkt der weichere Bereich, der aus polymerähnlichem a-C:H besteht, als Streßpuffer für den härteren Bereich der a-C:H-Schicht.

Besonders vorteilhaft besitzen die a-C:H-Schichten einen Härtegradient hart-weich-hart. Hierbei weist somit der an die Kunststoffschicht angrenzende Bereich eine größere Härte auf als der unmittelbar nachfolgende Bereich. Durch diesen unteren härteren Bereich wird eine innige Verbindung zwischen der a-C:H-Schicht und der Kunststoffschicht erreicht, d.h. dieser Bereich dient als Haftvermittler.

Die Dicke der a-C:H-Schichten beträgt im allgemeinen etwa 0,1 bis 5 µm. Die einzelnen Bereiche weisen, unabhängig vom Gradientenverlauf (weich-hart bzw. hart-weich-hart), vorzugsweise folgende Dicken auf:
- unterer harter Bereich: 5 bis 100 nm
- weicher Bereich: 100 bis 1000 nm
- oberer harter Bereich: 200 bis 4000 nm.

Die Kunststoffschichten bestehen im allgemeinen aus Polyimid oder Polybenzoxazol.

Zur Herstellung der Mehrlagenleiterplatten bzw. Multichipmodul-Substrate nach der Erfindung wird auf der Kunststoffschicht, d.h. auf dem Kunststoff des schichtförmigen Kunststoff/Leiterbahn-Verbundes, durch Hochfrequenz-Plasmaabscheidung gasförmiger Kohlenwasserstoffe eine dünne a-C:H-Schicht abgeschieden, welche einen Härtegradient aufweist. Vorzugsweise erfolgt die Plasmaabscheidung mittels Radiofrequenz (RF), d.h. im Bereich zwischen 0,1 und 100 MHz. Die Abscheidung kann aber auch mittels Mikrowellen erfolgen, d.h. im Bereich zwischen 0,1 und 1000 GHz.

Als gasförmige Kohlenwasserstoffe dienen vorzugsweise entweder Alkane, d.h. gesättigte aliphatische Kohlenwasserstoffe, wie Methan, Ethan und Propan, oder aromatische Kohlenwasserstoffe, wie Benzol und Benzolderivate, und zwar im dampfförmigen Zustand. Daneben können auch Alkene und Alkine eingesetzt werden, wie Ethen und Propen bzw. Acetylen, d.h. ungesättigte aliphatische Kohlenwasserstoffe, und ferner auch Cycloalkane, d.h. gesättigte cyclische Kohlenwasserstoffe, wie Cyclohexan.

Die Härte der abgeschiedenen a-C:H-Schichten, d.h. der Härtegradient, wird über die Hochfrequenzleistung bzw. die Selfbias-Spannung gesteuert. Dazu werden, unabhängig vom Gradientenverlauf, folgende Abscheidebedingungen eingehalten:
- unterer harter Bereich: -400 bis -1200 V
- weicher Bereich: -100 bis -200 V
- oberer harter Bereich: -400 bis -900 V.

Zur Abscheidung des zur Haftvermittlung dienenden unteren harten Bereiches der a-C:H-Schicht wird kurze Zeit bei Abscheidebedingungen gearbeitet, bei denen Ionen hoher Energie abgeschieden werden, beispielsweise ca. 10 s bei etwa -900 V. Die Abscheidung des mittleren weichen Bereiches erfolgt dann bei etwa -150 V und die Abscheidung des oberen harten Bereiches bei etwa -450 V oder etwa -800 V.

Vorteilhaft kann vor der a-C:H-Abscheidung eine Oberflächenbehandlung in einem Argon- oder Sauerstoffplasma vorgenommen werden, die zur weiteren Verbesserung der Haftung dient. Die Argon-Vorbehandlung erfolgt vorzugsweise bei einer Selfbias-Spannung von -500 bis -1200 V für 2 bis 180 s, die Sauerstoff-Vorbehandlung vorzugsweise bei einer Selfbias-Spannung von -500 bis -1000 V für 1 bis 20 s. Die Behandlung im Argonplasma wird beispielsweise bei etwa -900 V für 30 s durchgeführt, die Behandlung im Sauerstoffplasma beispielsweise bei etwa -800 V für 10 s.

Zur Herstellung der a-C:H-Schichten dient beispielsweise eine Apparatur zur Plasmaabscheidung mittels RF-Anregung, die eine Parallelplattenanordnung aufweist. In diese Apparatur wird Methan (CH₄) als Reaktionsgas bei einem Druck von 0,2 bar eingeleitet. Ein zu beschichtendes MCM-Substrat befindet sich auf der kleineren der beiden Elektroden (Kathode), die über eine Matching Unit mit einem Hochfrequenzsender (13,56 MHz) verbunden ist. Das Flächenverhältnis der beiden Elektroden (Kathode:Anode) ist kleiner als 0,5.

Zur Beschichtung mit a-C:H wird zunächst - für die Dauer von 10 s - eine Abscheideleistung gewählt, die eine Selfbias-Spannung von -900 V ergibt; dabei entsteht harter a-C:H. Anschließend wird die Leistung so weit reduziert, daß sich eine Selfbias-Spannung von -150 V einstellt. Nach ca. 12 min beträgt die Schichtdicke des entstandenen weichen a-C:H ca. 0,2 µm. Dann wird die Leistung bis zu einer Selfbias-Spannung von -800 V erhöht. Bei dieser Leistung wird erneut harter a-C:H abgeschieden, und zwar mit einer Dicke von 0,5 µm innerhalb von ca. 7 min. Dieser a-C:H-Bereich weist einen Wasserpermeationskoeffizient < 1,1.10⁻¹³ m²/s auf und ist gegen Wasser sehr dicht.

Die Vorbehandlung der Substrate findet zweckmäßigerweise in der gleichen Apparatur statt. Dazu wird Argon bzw. Sauerstoff bei einem Druck von 0,2 bar eingeleitet und beispielsweise bei -800 V das Plasma gezündet; Dauer: 120 s bei Argon, 20 s bei Sauerstoff. Bei der Vorbehandlung im Argonplasma wird anschließend, ohne den Hochfrequenzsender abzustellen, der Argondurchfluß gestoppt und gleichzeitig Methan zugeführt, wobei der Durchfluß so geregelt wird, daß sich ein Druck von 0,2 bar einstellt. Beim Arbeiten mit einem Sauerstoffplasma wird nach Beendigung der Vorbehandlung der Sauerstoffzufluß unterbrochen, dann wird auf ca. 10⁻³ mbar evakuiert und nachfolgend Methan bei einem Druck von 0,2 bar eingeleitet.

## Patentansprüche

1. Mehrlagenleiterplatten und Multichipmodul-Substrate mit wenigstens einem schichtförmigen Verbund aus hochtemperaturheständigen Kunststoff und metallischen Leiterbahnen, **dadurch gekennzeichnet, daß** der Kunststoff mit einer dünnen Schicht aus amorphem wasserstoffhaltigem Kohlenstoff (a-C:H) mit einem Wasserpermeationskoeffizient < 1,1·10⁻¹³ m²/s versehen ist, und daß die a-C:H-Schicht bezüglich der Härte einen Gradient besitzt, wobei der an den Kunststoff angrenzende Bereich eine geringere Härte aufweist als der äußere Bereich.

2. Mehrlagenleiterplatten und Multichipmodul-Substrate nach Anspruch 1, **dadurch gekennzeichnet, daß** der amorphe wasserstoffhaltige Kohlenstoff bezüglich der Härte einen Schichtgradient hart-weich-hart besitzt.

3. Mehrlagenleiterplatten und Multichipmodul-Substrate nach Anspruch 1 oder 2, **dadurch gekennzeichnet, daß** die a-C:H-Schicht eine Dicke zwischen 0,1 und 5 µm aufweist.

4. Verfahren zur Herstellung von Mehrlagenleiterplatten und Multichipmodul-Substraten nach einem der Ansprüche 1 bis 3, **dadurch gekennzeichnet, daß** auf den hochtemperaturheständigen Kunststoff eines schichtförmigen Kunststoff/Leiterbahn-Verbundes durch Hochfrequenz-Plasmaabscheidung gasförmiger Kohlenwasserstoffe eine dünne a-C:H-Schicht mit einem Härtegradient abgeschieden wird wobei der an den Kunststoff angrenzende Bereich eine geringere Härte aufweist als der äußere Bereich.

5. Verfahren nach Anspruch 4, **dadurch gekennzeichnet, daß** die Plasmaabscheidung mittels Radiofrequenz erfolgt.

6. Verfahren nach Anspruch 4 oder 5, **dadurch gekennzeichnet, daß** als Kohlenwasserstoffe Alkane oder aromatische Kohlenwasserstoffe verwendet werden.

7. Verfahren nach einem der Ansprüche 4 bis 6, **dadurch gekennzeichnet, daß** vor der a-C:H-Abscheidung eine Oberflächenbehandlung in einem Argon- oder Sauerstoffplasma vorgenommen wird.

## Claims

1. Multilayer printed circuit boards and multichip module substrates having at least one layered composite comprising high-temperature-resistant plastic and metallic conductor tracks, **characterized in that** the plastic is provided with a thin layer made of amorphous hydrogen-containing carbon (a-C:H) having a water permeation coefficient < 1.1·10⁻¹³ m²/s, and **in that** the a-C:H layer has a gradient with regard to the hardness, the region which adjoins the plastic having a lower hardness than the outer region.

2. Multilayer printed circuit boards and multichip module substrates according to Claim 1, **characterized in that** the amorphous hydrogen-containing carbon has a layer gradient hard-soft-hard with regard to the hardness.

3. Multilayer printed circuit boards and multichip module substrates according to Claim 1 or 2, **characterized in that** the a-C:H layer has a thickness of between 0.1 and 5 µm.

4. Method for producing multilayer printed circuit boards and multichip module substrates according to one of Claims 1 to 3, **characterized in that** a thin a-C:H layer having a hardness gradient is deposited on the high-temperature-resistant plastic of a layered plastic/conductor track composite by high-frequency plasma deposition of gaseous hydrocarbons, the region which adjoins the plastic having a lower hardness than the outer region.

5. Method according to Claim 4, **characterized in that** the plasma deposition is effected by means of radio frequency.

6. Method according to Claim 4 or 5, **characterized in that** the hydrocarbons used are alkanes or aromatic hydrocarbons.

7. Method according to one of Claims 4 to 6, **characterized in that** a surface treatment in an argon or oxygen plasma is performed prior to the a-C:H deposition.

## Revendications

1. Plaquette à circuit imprimé à multicouche et substrat pour module à multipuce comprenant au moins un composite en forme de couche constitué de matière plastique résistant aux hautes températures et de pistes conductrices métalliques, **caractérisée en ce que** la matière plastique est munie d'une couche mince en carbone amorphe contenant de l'hydrogène (C-a:H) ayant un coefficient de perméation à l'eau inférieur à 1,1.10⁻¹³ m²/s, et **en ce que** la couche de C-a:H a, pour ce qui concerne la dureté, un gradient, la partie voisine de la matière plastique ayant une dureté plus petite que la partie extérieure.

2. Plaquette à circuit imprimé à multicouche et substrat pour module à multipuce suivant la revendication 1, **caractérisée en ce que** la dureté du carbone amorphe contenant de l'hydrogène présente un gradient de couche dur-tendre-dur.

3. Plaquette à circuit imprimé à multicouche et substrat pour module à multipuce suivant la revendication 1 ou 2, **caractérisée en ce que** la couche C-a:H a une épaisseur comprise entre 0,1 et 5 µm.

4. Procédé de fabrication de plaquette à circuit imprimé à multicouche et de substrat pour module à multipuce suivant l'une des revendications 1 à 3, **caractérisé en ce que** l'on dépose sur la matière plastique résistant aux températures hautes d'un composite matière plastique/piste conductrice en forme de couche, par dépôt au plasma à haute fréquence d'hydrocarbure gazeux, une mince couche de C-a:H ayant un gradient de dureté.

5. Procédé suivant la revendication 4, **caractérisé en ce que** l'on effectue le dépôt au plasma au moyen d'une radiofréquence.

6. Procédé suivant la revendication 4 ou 5, **caractérisé en ce qu'**on utilise, comme hydrocarbures, des alcanes ou des hydrocarbures aromatiques.

7. Procédé suivant l'une des revendications 4 à 6, **caractérisé en ce qu'**avant le dépôt de C-a:H, on effectue un traitement de surface dans un plasma d'argon ou d'oxygène.
